# EUROPEAN PATENT SPECIFICATION

(11) **EP 3 282 489 B1**
(45) Date of publication and mention of the grant of the patent: **06.10.2021**
(21) Application number: 17185706.3
(22) Date of filing: 10.08.2017
(51) Int. Cl.: H01L 31/048, H02S 20/30

(54) **PHOTOVOLTAIC MODULE**
PHOTOVOLTAISCHES MODUL
MODULE PHOTOVOLTAÏQUE

(30) Priority: 11.08.2016 KR 20160102423
(43) Date of publication of application: 14.02.2018
(73) Proprietor: LG ELECTRONICS INC., Yeongdeungpo-gu Seoul 07336 (KR)
(72) Inventor: JEON, Joonho, 08592 Seoul (KR); KIM, Jungguen, 08592 Seoul (KR); SONG, Yong, 08592 Seoul (KR); WOO, Jeonghun, 08592 Seoul (KR); HWANG, Eonjoo, 08592 Seoul (KR)
(74) Representative: Katérle, Axel

(56) References cited:
- EP-A2- 2 557 603
- JP-A- 2015 057 811
- US-A1- 2012 305 080
- US-A1- 2014 352 764

## Description

### BACKGROUND OF THE INVENTION

### 1. Field of the Invention

The present disclosure relates to a photovoltaic module including a solar cell and having a curved surface.

### 2. Background of the Invention

A solar cell is configured to convert light energy into an electric energy. In general, a solar cell includes a P type semiconductor and an N type semiconductor, and when the solar cell receives light, electric charges migrate to cause a potential difference.

A photovoltaic module refers to a module having a solar cell to produce electric power from light. A module refers to a constituent unit of a machine or a system and indicates an independent unit assembled to several electronic components or mechanical components to have a specific function. Thus, the photovoltaic module may be understood as indicating an independent unit having a solar cell and having a function of producing electric power from light.

The photovoltaic module is applied to a roof of an automobile or an interior or exterior material of a building, electric power may be applied using 1) indoor light supplied from a fluorescent lamp or a light emitting diode (LED) or 2) natural light supplied from the sun, even without having to connect a separate power cable. Glass is disposed on an outermost layer of a photovoltaic module applied to a roof of an automobile or an interior or exterior material of a building, and here, the glass may have a curved surface due to a function, a design, and the like.

A solar cell formed of crystalloid may have flexibility to a degree, but a solar cell adhered to curved glass may be cracked in a corner portion.

Also, bubbles generated in the process of manufacturing a photovoltaic module may remain to act as a defect of a photovoltaic module. In addition, a solar cell module may move during a manufacturing process of a photovoltaic module to produce a product having a design different to an initial design. US 2014/352764 A1 discloses that a sticking member 210 is interposed between a solar cell panel 200 and a finishing member 220 as well as between an upper surface 300 of a vehicle and the solar cell panel 200. Then, a bonding layer 211 is additionally disposed on both surfaces of a sticking member 210, and thereby the sticking member 210 is to be stably bonded and fixed between the upper surface 300 of the vehicle and the solar cell panel 200 and between the solar cell panel 200 and the finishing member 220.

Curved photovoltaic modules are further disclosed in US 2012/305080 A1, wherein the solar cells are encapsulated in multiple layer arrangements.

### SUMMARY OF THE INVENTION

The present invention is defined by the independent claims. Specific embodiments are defined by the dependent claims. An aspect of the detailed description is to provide a structure in which a solar cell is not broken in a photovoltaic module having curved glass.

Another aspect of the detailed description is to provide a method for manufacturing a photovoltaic module eliminating generation of bubbles and movement of a solar cell during a manufacturing process of a photovoltaic module having a curved glass.

To achieve these and other advantages and in accordance with the purpose of this specification, as embodied and broadly described herein, an example photovoltaic module may include: a solar laminated assembly; a first glass adhered to one surface of the solar laminated assembly; a back sheet or second glass adhered to the other surface of the solar laminated assembly; and encapsulant layers adhering the first glass to the solar laminated assembly and adhering the back sheet or second glass to the solar laminated assembly.

A concept of the solar laminated assembly and a detailed configuration of the encapsulant layers may differ according to examples. Also, according to an example, the photovoltaic module may selectively include films configured to protect the solar laminated assembly.

The photovoltaic module of the present disclosure may be classified into first to third embodiments depending on whether films are removed from the solar laminated assembly. A photovoltaic module of the first embodiment has a structure including a first film and a second film as films are not removed from the solar laminated assembly. A photovoltaic module of the second embodiment has a structure in which both a first film and a second film are removed from the solar laminated assembly. A photovoltaic module of the third embodiment has a structure in which only a first film is removed from the solar laminated assembly.

The photovoltaic module of the first embodiment, which does not form a part of the invention and is to be considered as an example suitable for understanding the invention, may include: a solar laminated assembly including at least one solar cell having a first surface and a second surface in mutually opposite directions, first and second films disposed to cover the first and second surfaces, respectively, a first encapsulant layer disposed between the first surface and the first film to adhere the solar cell and the first film, and a second encapsulant layer disposed between the second surface and the second film to adhere the solar cell and the second film; a first glass having a curved surface and covering the first film; a back sheet or second glass covering the second glass; a third encapsulant layer disposed between the first film and the first glass to adhere the first film and the first glass; and a fourth encapsulant layer disposed between the second film and the back sheet to adhere the second film and the back sheet or disposed between the second film and the second glass to adhere the second film and the second glass.

The first to fourth encapsulant layers may be formed of a thermosetting resin or a thermoplastic resin.

The third encapsulant layer and the fourth encapsulant layer may be thicker than the first encapsulant layer and the second encapsulant layer.

The first film may be formed of a transparent material. The transparent material may be polyethylene terephthalate (PET), for example.

When the back sheet of the photovoltaic module is formed of a transparent material or when the photovoltaic module includes a second glass, the second film may be formed of a transparent material. The transparent material may be PET. When the back sheet of the photovoltaic module is black or white, the second film may have a color to strengthen visibility.

An example photovoltaic module of the second embodiment may include: at least one solar cell having a first surface and a second surface in mutually opposite directions; a first glass having a curved surface and covering the first surface; a back sheet or second glass covering the second surface; a first encapsulant layer disposed between the first surface and the first glass to adhere the solar cell and the first glass; and a second encapsulant layer disposed between the second surface and the back sheet to adhere the solar cell and the back sheet or disposed between the second surface and the second glass to adhere the solar cell and the second glass.

The first encapsulant layer and the second encapsulant layer may be formed of a thermosetting resin, and which are stacked to form two layers. Among the two layers, a layer disposed to be relatively away from the solar cell may be thicker than a layer disposed to be relatively close to the solar cell.

The first encapsulant layer and the second encapsulant layer may include a first layer adhered to the solar cell; and a second layer adhered to the first glass or adhered to the back sheet or second glass. Any one of the first layer and the second layer may be formed of a thermosetting resin and the other may be formed of a thermoplastic resin.

A thickness of the first encapsulant layer and the encapsulant layer may range from 450*µ*m to 1,100*µ*m, and may be formed of a thermosetting resin.

The first encapsulant layer and the second encapsulant layer may be formed of a thermoplastic resin.

To achieve these and other advantages and in accordance with the purpose of this specification, as embodied and broadly described herein, an example method for manufacturing a photovoltaic module is provided. The photovoltaic module of the present disclosure may be manufactured by previously manufacturing a solar laminated assembly through a first lamination process, and post-adhering a) a first glass and b) a back sheet or second glass to the solar laminated assembly. A detailed configuration may be varied according to embodiments.

The manufacturing method of the first embodiment, which does not form a part of the invention and is to be considered as an example suitable for understanding the invention, may include: a first operation of manufacturing a solar laminated assembly having a structure in which a first encapsulant layer and a first film are sequentially stacked on a first surface of a solar cell and a second encapsulant layer and a second film are sequentially stacked on a second surface of the solar cell; and a second operation of adhering a first glass having a curved surface to a first surface of the solar laminated assembly and adhering a second glass having a curved surface to a back sheet of a second surface of the solar laminated assembly, wherein the first operation includes: sequentially stacking a first encapsulant layer and a first film on the first surface of the solar cell and sequentially stacking a second encapsulant layer and a second film on the second surface of the solar cell; and adhering the first film to the first surface of the solar cell and adhering the second film to the second surface of the solar cell through a first lamination process of applying heat to the first encapsulant layer and the second encapsulant layer, while pressing the first film and the second film in a direction toward each other.

The second operation may include: disposing a third encapsulant layer between the first film and the first glass and disposing a fourth encapsulant layer between the second film and the back sheet or between the second film and the second glass; and adhering the first glass to the first surface of the solar laminated assembly and adhering the back sheet or the second glass to the second surface of the solar laminated assembly through a second lamination process of applying heat and pressure within a hermetically closed chamber.

The first to fourth encapsulant layers may be formed of a thermosetting resin or a thermoplastic resin.

The first encapsulant layer and the second encapsulant layer may be thicker than the third encapsulant layer and the fourth encapsulant layer.

At least one of the first film and the second film may be formed of a transparent material.

A manufacturing method of the second embodiment according to the invention includes: a process of removing the first film and the second film after the first lamination process in the first operation. Thereafter, a photovoltaic module is completed through the second lamination process of the second operation.

In the first operation, a solar laminated assembly is manufactured. The first operation includes: sequentially stacking a first layer of a first encapsulant layer and a first film on a first surface of the solar cell and sequentially stacking a first layer of a second encapsulant layer and a second film on a second surface of the solar cell; and adhering the first film to the first surface of the solar cell and adhering the second film to the second surface of the solar cell through the first lamination process of applying heat to the first layers of the first encapsulant layer and the second encapsulant layer, while pressing the first film and the second film in a direction toward each other.

The manufacturing method of the second embodiment includes: removing the first film and the second film from the solar laminated assembly after the first operation.

The second operation includes: additionally disposing a second layer of the first encapsulant layer between the first layer of the first encapsulant layer exposed as the first film was removed and a first substrate and additionally disposing a second layer of the second encapsulant layer between the first layer of the second encapsulant layer exposed as the second film was removed and a second substrate; and adhering the first substrate to the first surface of the solar laminated assembly and adhering the second substrate to the second surface of the solar laminated assembly through a second lamination process of applying heat and pressure within a hermetically closed chamber.

The first encapsulant layer and the second encapsulant layer are formed of a thermosetting resin and stacked as two layers. Among the two layers, the second layer disposed to be relatively further from the solar cell is thicker than the first layer disposed to be relatively closer to the solar cell.

In another exemplified manufacturing method of the second embodiment, which does not form a part of the invention and is to be considered as an example suitable for understanding the invention, a thermoplastic resin may be included in the solar laminated assembly, and thus, an additional encapsulant layer for the second lamination process may be not required in the second operation after removing the first film and the second film. This will be described hereinafter.

The first operation may be performed to manufacture a solar laminated assembly. the first operation may include: sequentially stacking a first encapsulant layer and a first film on a first surface of a solar cell and sequentially stacking a second encapsulant layer and a second film on a second surface of the solar cell; and adhering the first film to the first surface of the solar cell and adhering the second film to the second surface of the solar cell through the first lamination process of applying heat to the first encapsulant layer and the second encapsulant layer, while pressing the first film and the second film in a direction toward each other. Here, the first encapsulant layer and the second encapsulant layer may be formed of a thermoplastic resin and may be configured as a single layer. Or, the first encapsulant layer and the second encapsulant layer may include a first layer adhered to the solar cell and a second layer adhered to a first glass or adhered to a back sheet or second glass, and any one of the first layer and the second layer may be formed of a thermosetting resin and the other may be formed of a thermoplastic resin.

The first layer may be formed of a thermosetting resin and may be disposed to cover the solar cell in the first operation. The second layer may be formed of a thermoplastic resin and may be disposed to cover the first layer in the second operation.

After the first operation, the first film and the second film may be removed from the solar laminated assembly.

The second operation may include adhering a first glass to a first surface of the solar laminated assembly and adhering a back sheet or second glass to a second surface of the solar laminated assembly through a second lamination process of applying heat and pressure within a hermitically closed chamber. Since the thermoplastic resin used as the first encapsulant layer and the second encapsulant layer of the solar laminated assembly is melted again and cured in the second lamination process, an additional encapsulant layer is not required in the second operation.

A manufacturing method of the third embodiment, which does not form a part of the invention and is to be considered as an example suitable for understanding the invention, is distinguished from the first embodiment and the second embodiment described above, in that only a first film is removed after a first operation and a second operation is performed while a second film is maintained. Hereinafter, the manufacturing method of the third embodiment will be described.

The first operation may be performed to manufacture a solar laminated assembly. The first operation may include sequentially stacking a first encapsulant layer and a first film on a first surface of a solar cell and sequentially stacking a second encapsulant layer and a second film on a second surface of the solar cell; and adhering the first film to the first surface of the solar cell and adhering the second film to the second surface of the solar cell through the first lamination process of applying heat to the first encapsulant layer and the second encapsulant layer, while pressing the first film and the second film in a direction toward each other. The first encapsulant layer and the second encapsulant layer may be formed of a thermosetting resin or a thermoplastic resin.

The manufacturing method of the third embodiment may further include: removing the first film from the solar laminated assembly after the first operation.

The second operation may be varied according to a configuration of the first encapsulant layer and the second encapsulant layer disposed in the first operation.

For example, the first encapsulant layer may include a first layer adhered to a solar cell and formed of a thermosetting resin; and a second layer adhered to a first glass in the second operation and formed of a thermoplastic resin, and the second encapsulant layer may be formed of a thermosetting resin. Here, the second steep may include: additionally disposing a third encapsulant layer formed of a thermosetting resin between the second film and a back sheet or between the second film and a second glass; and performing a second lamination process of applying heat and pressure within a hermetically closed chamber.

In another example, both the first encapsulant layer and the second encapsulant layer may be formed of a thermosetting resin. Here, the second operation may include: additionally disposing an encapsulant layer which is the same as the first encapsulant layer between the first encapsulant layer and the first glass and additionally disposed a third encapsulant layer formed of a thermosetting resin between the second film and the back sheet or between the second film and the second glass; and performing a second lamination process of applying heat and pressure within a hermetically closed chamber.

Also, in another example, both the first encapsulant layer and the second encapsulant layer may be formed of a thermoplastic resin. Here, the second operation may include: additionally disposing a third encapsulant layer formed of a thermosetting resin between the second film and the back sheet or between the second film and the second glass; and performing a second lamination process of applying heat and pressure within a hermitically closed chamber.

In each embodiment, the second lamination process may include a preliminary adhering operation of partially melting 1) the third encapsulant layer in contact with the first glass and 2) the fourth encapsulant layer in contact with the back sheet or the second glass by introducing the solar laminated assembly to the inside of the hermitically closed chamber, vacuating the inside of the hermitically closed chamber, and substantially applying heat; and a main adhering operation of entirely melting 1) the third encapsulant layer in contact with the first glass and 2) the fourth encapsulant layer in contact with the back sheet or the second glass by applying heat and pressure to the solar laminated assembly within the hermetically closed chamber and subsequently curing the encapsulant layers. In both of the first lamination process and the second lamination process, the adhering operation may be used by applying both heat and pressure.

Further scope of applicability of the present application will become more apparent from the detailed description given hereinafter. However, it should be understood that the detailed description and specific examples, while indicating preferred embodiments of the invention, are given by way of illustration only, since various changes and modifications within the scope of the invention will become apparent to those skilled in the art from the detailed description.

### BRIEF DESCRIPTION OF THE DRAWINGS

The accompanying drawings, which are included to provide a further understanding of the invention and are incorporated in and constitute a part of this specification, illustrate example embodiments and together with the description serve to explain the principles of the invention.

In the drawings:
FIG. 1 is a conceptual view illustrating a photovoltaic module according to a first embodiment.
FIGS. 2A and 2B are conceptual views illustrating a photovoltaic module according to a second embodiment.
FIGS. 3A and 3B are conceptual views illustrating a photovoltaic module according to a third embodiment.
FIG. 4 is a common flow chart illustrating a method for manufacturing a photovoltaic module.
FIG. 5 is a detailed flow chart illustrating a method for manufacturing a photovoltaic module according to a first embodiment.
FIGS. 6A and 6B are conceptual views illustrating a process of manufacturing a photovoltaic module according to the flow charts illustrated in FIGS. 4 and 5.
FIG. 7 is a detailed flow chart illustrating a method for manufacturing a photovoltaic module according to a second embodiment.
FIGS. 8A to 8C are conceptual views illustrating a process of manufacturing a photovoltaic module according to the flow charts illustrated in FIGS. 4 and 7.
FIG. 9 is a detailed flow chart illustrating another method for manufacturing a photovoltaic module according to the second embodiment.
FIGS. 10A to 10C are conceptual views illustrating a process of manufacturing a photovoltaic module according to the flow charts illustrated in FIS. 4 and 9.
FIGS. 11A to 11C are other conceptual views illustrating a process of manufacturing a photovoltaic module according to the flow charts illustrated in FIGS. 4 and 9.
FIG. 12 is a detailed flow chart illustrating a method for manufacturing a photovoltaic module according to a third embodiment.
FIG. 13 is a detailed flow chart illustrating another method for manufacturing a photovoltaic module according to the third embodiment.

### DETAILED DESCRIPTION OF THE INVENTION

Description will now be given in detail of the example embodiments, with reference to the accompanying drawings. For the sake of brief description with reference to the drawings, the same or equivalent components will be provided with the same reference numbers, and description thereof will not be repeated.

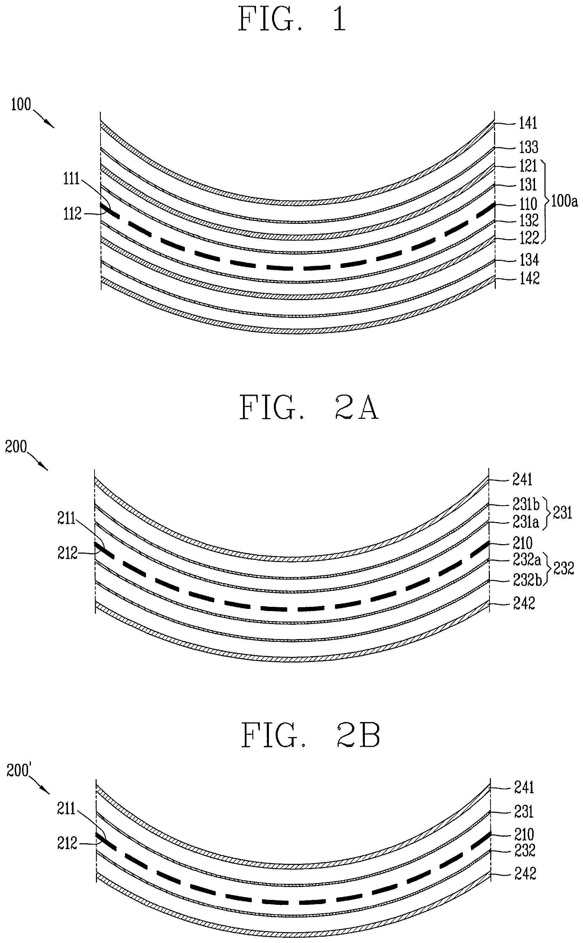

FIG. 1 is a conceptual view of a photovoltaic module 100 according to a first embodiment, which does not form a part of the invention and is to be considered as an example suitable for understanding the invention. A multilayer structure of the photovoltaic module 100 is illustrated in FIG. 1.

The photovoltaic module 100 includes a solar laminated assembly 100a, a first glass (a first substrate) 141 covering one side of the solar laminated assembly 100a, and a back sheet or second glass (a second substrate) 142 covering the other side of the solar laminated assembly 100a.

The solar laminated assembly 100a refers to a solar cell 110 and elements configured to protect the solar cells 110, excluding a) the first glass 141 and b) the back sheet or second glass 142, forming the outermost layers of the photovoltaic module 100. In the present disclosure, the solar laminated assembly 100a refers to a half-finished product previously manufactured during a process of manufacturing the photovoltaic module 100, and a concept of the solar laminated assembly 100a may differ depending on embodiments.

The solar laminated assembly 100a according to the first embodiment includes at least one solar cell 110, films 121 and 122 disposed to cover opposing surfaces of the solar cell 110, and encapsulant layers 131 and 132 adhering the films 121 and 122 to the solar cell 110.

One or a plurality of solar cells 110 may be provided depending on a design of the photovoltaic module 100. When the solar cell 110 is provided in a plurality, the plurality of solar cells may be disposed to be spaced apart from each other and may be connected in series to form a string. Also, the solar cells 110 may be disposed on the same curved surface. Referring to FIG. 1, the solar cells 110 are disposed between a curved surface of the first encapsulant layer 131 and a curved surface of the second encapsulant layer 132.

Each solar cell 110 has a first surface 111 and a second surface 112 which face in mutually opposite directions. Light may be received (or collected) only to any one of the first surface 111 and the second surface 112 or to both of them. Here, first and second ordinal numbers are merely used for discriminating therebetween, without any specific technical meaning.

The films 121 and 122 are disposed to cover the solar cell 110. The films 121 and 122 include a first film 121 and a second film 122 disposed to cover different surfaces. The first film 121 is disposed to cover the first surface 111 of the solar cell 110, and the second film 122 is disposed to cover the second surface 112 of the solar cell 110.

The first film 121 and the second film 122 form outermost surfaces of the solar laminated assembly 100a and are configured to protect opposing surfaces of the solar cell 110. For example, a physical impact, moisture, and the like, may affect the solar cell 100, and here, the first film 121 and the second film 122 may protect the solar cell 110 from a physical impact or moisture.

In particular, as described hereinafter, in the method for manufacturing the photovoltaic module 100, after the solar laminated assembly 100a is first manufactured in a first operation (a first laminating operation), a) the first glass 141 and b) the back sheet or second glass 142 are adhered to the solar laminated assembly 100a in a second operation (a second laminating operation), and here, the films 121 and 122 serve to protect the solar cell 110 between the first operation and the second operation.

At least one of the films 121 and 122 may be formed of a transparent material. In order for the solar cell 110 to produce sufficient electric power, sufficient light has to be provided, and thus, the film covering a light receiving surface of the solar cell 110 is formed of a transparent material. For example, in instance where both the first surface 111 and the second surface 112 of the solar cell 110 receive light, both the first film 121 and the second film 122 are formed of a transparent material. In instance where only any one of the first surface 111 and the second surface 112 of the solar cell 110 receives light, only any one of the first film 121 and the second film 122 may be formed of a transparent material and the other may be formed of an opaque material. Even in instance where only any one of the first surface 111 and the second surface 112 of the solar cell 110 receives light, not all of the first film 121 and the second film 122 are required to be formed of a transparent material. However, when the photovoltaic module 100 is applied to an automobile roof or the interior/exterior material of a building, preferably, a film covering the opposite surface of the light receiving surface, among the first film 121 and the second film 122, is formed of an opaque material in order to prevent an indoor area of the automobile or the building from being visually exposed through the photovoltaic module 100.

When light is received by the first surface 111 of the solar cell 110, the first film 121 may be formed of a transparent material, and here, the transparent material may be formed of polyethylene terephthalate (PET). In instance where the back sheet 142 of the photovoltaic module 100 is formed of a transparent material or in instance where the photovoltaic module 100 includes the second glass 142 (glass is always transparent), the second film 122 may be formed of a transparent material. The transparent material may be formed of PET, like the first film 121. In instance where the back sheet 141 of the photovoltaic module 100 has a color such as black or white, the second film 122 may have a color to strengthen visibility.

The encapsulant layers 131 and 132 protect the solar cell 110, and serve to adhere the films 121 and 122 to the solar cell 110, respectively. The encapsulant layers 131 and 132 include a first encapsulant layer 131 and a second encapsulant layer 132. The first encapsulant layer 131 is disposed between the first surface 111 and the first film 121 to adhere the first film 121 to the solar cell 110. The second encapsulant layer 132 is disposed between the second surface 112 and the second film 122 to adhere the second film 122 to the solar cell 110.

In the present disclosure, the encapsulant layers 131, 132, 133, and 134 may be formed of a thermoplastic resin or a thermosetting resin. This may also be equally applied to the other embodiments, as well as to the first embodiment.

Thermoplasticity refers to properties deformed when heat is applied again after being formed by applying heat. In contrast, thermosetting properties refers to properties not deformed although heat is applied again, once deformed by applying heat.

In the present disclosure, types of a thermoplastic resin or thermosetting resin is not particularly limited. Any maternal may be used as a material of the encapsulant layer of the present disclosure as long as it is transparent, has adhesion when cured, and has thermoplasticity or thermosetting properties. For example, thermoplastic olefine (TPO), polyvinyl butyral (PVB), or polycarbonate (PC), which is transparent, has adhesion when cured, and has thermoplasticity, may be used as a material of the encapsulant layer of the present disclosure. Also, ethylene-vinyl acetate (EVA), which is transparent, has adhesion, and has thermosetting properties, may be used as a material of the encapsulant layer of the present disclosure.

In the photovoltaic module 100 of the first embodiment, the first encapsulant layer 131 and the second encapsulant layer 132 are preferably formed of a thermosetting resin. The photovoltaic module 100 of the first embodiment further includes a third encapsulant layer 133 and a fourth encapsulant layer 134 because arbitrary deformation of the first encapsulant layer 131 and the second encapsulant layer 132 is not desired in the process of thermosetting the third encapsulant layer 133 and the fourth encapsulant layer 134. However, the first encapsulant layer 131 and the second encapsulant layer are not necessarily formed of a thermosetting resin and may be formed of any other material.

The first glass (first substrate) 141 is disposed to cover the first film 121. The first glass 141 is adhered to the first film 121 by the third encapsulant layer 133 described hereinafter. The first glass 141 forms an outermost surface of one side of the photovoltaic module 100 and the first glass 141 may be referred to as a first outermost layer.

The first glass 141 has a curved surface. Here, however, the first glass 141 may not be entirely formed as a curved surface and only a partial region of the first glass 141 may be formed as a curved surface.

The back sheet or second glass (second substrate) 142 is disposed to cover the second film 122. The back sheet or second glass 142 is adhered to the second film 122 by the fourth encapsulant layer 134 described hereinafter. The back sheet or second glass 142 is provided on the other outermost surface of the photovoltaic module 100 and may be referred to as a second outermost layer having a concept including the back sheet or second glass 142.

In the photovoltaic module 100, the back sheet or second glass 142 has a curved surface corresponding to the first glass 141. The back sheet does not originally have a curved surface and as the back sheet is adhered to the solar laminated assembly 100a, the back sheet forms a curved surface according to a curvature of the first glass. A curvature of the back sheet or second glass 142 may be substantially the same as that of the first glass 141 within an error range. Like the first glass 141, a partial region of the back sheet or second glass 142 may also be formed as a curved surface.

The photovoltaic module 100 is not required to have both the back sheet and the second glass and may have only any one of the back sheet and the second glass 142. For example, in instance where the photovoltaic module 100 is applied to an automobile roof, the photovoltaic module 100 may have a back sheet, and here, the first surface 111 of the solar cell 110 is a light receiving surface.

In instance where the photovoltaic module 100 has the second glass 142, one side and the other side with respect to the solar cell 110 are symmetrical. Here, the first surface 111 and the second surface 112 of the solar cell 110 may not necessarily be distinguished.

The third encapsulant layer 133 is disposed between the first film 121 and the first glass 141 to adhere the first film 121 and the first glass 141. Also, the fourth encapsulant layer 134 may be disposed between the second film 122 and the back sheet to adhere the second film 122 and the back sheet or disposed between the second film and the second glass 142 to adhere the second film 122 and the second glass 142. Descriptions of the first encapsulant layer 133 and the second encapsulant layer 134 may also be applied to the third encapsulant layer 33 and the fourth encapsulant layer 134.

Thicknesses of the third encapsulant layer 133 and the fourth encapsulant layer 134 may be greater than those of the first encapsulant layer 131 and the second encapsulant layer 132. When the thickness of the encapsulant layer is greater, adhesion may be increased, and since the third encapsulant layer 133 and the fourth encapsulant layer 134 are used to adhere the glasses 141 and 142 heavier than the films 121 and 122, the third encapsulant layer133 and the fourth encapsulant layer 134 may be thicker than the first encapsulant layer 131 and the second encapsulant layer 132.

As the first glass 141 has a curved surface and the second glass 142 has a curved surface, the solar cell 110, the films 121 and 122, and the encapsulant layers 131, 132, 133, and 134 disposed therebetween also have a curved surface. This is because the first glass 141 has rigidity. Since a size of one solar cell 110 is smaller than the films 121 and 122 or the first glass 141, although the solar cell 110 is bent, deformation of the solar cell 110 is smaller than that of the films 121 and 122 or the encapsulant layers 131, 132, 133, and 134. Also, the films 121 and 122 and the encapsulant layers 131, 132, 133, and 134 are flexible to be bendable.

Thus, in the photovoltaic module 100 having the structure in which the first glass 141 and the back sheet or second glass 142 are adhered to the solar laminated assembly 100a, a corner of the solar cell 110 is not broken.

Hereinafter, another embodiment of the present disclosure will be described. Here, the same description of another embodiment as that of the first embodiment will be omitted.

FIGS. 2A and 2B are conceptual views illustrating example photovoltaic modules 200 and 200' according to a second embodiment. In FIGS. 2A and 2B, multilayer structures of the two photovoltaic modules 200 and 200' are illustrated, respectively.

The photovoltaic modules 200 and 200' of the second embodiment are distinguished from the first embodiment in that they do not include the films 121 and 122 (please refer to FIG. 1) and do not include the third encapsulant layer 133 (please refer to FIG. 1) and the fourth encapsulant layer 134 (please refer to FIG. 1).

In the photovoltaic modules 200 and 200' of the second embodiment, a first encapsulant layer 231 is disposed between a solar cell 210 and a first glass (a first substrate) 241 and adhered to the solar cell 210 and the first glass 241. A second encapsulant layer 232 is disposed between the solar cell 210 and a back sheet or between the solar cell 210 and a second glass (a second substrate) 242 and adhered to the solar cell 210 and the back sheet or adhered to the solar cell 210 and the second glass 242.

The second embodiment may be classified as embodiment 2-1, and embodiment 2-2 which does not form a part of the invention and is to be considered as an example suitable for understanding the invention. The photovoltaic module 200 of the embodiment 2-1 has a first encapsulant layer and a second encapsulant layer each including two layers, whereas the photovoltaic module 200' of the embodiment 2-2 has a first encapsulant layer and a second encapsulant layer each including one layer.

In the photovoltaic module 200 of the embodiment 2-1 illustrated in FIG. 2A, the first encapsulant layer 231 and the second encapsulant layer 232 each include two layers. In order to distinguish between the two layers of the first encapsulant layer 231 and in order to distinguish between the two layers of the second encapsulant layer 232, layers of the first and second encapsulant layers 231 and 232 which are adhered to the solar cell 210 will be termed first layers 231a and 232a and layers thereof which are adhered to the first glass 241 or the back sheet or second glass 242 will be termed second layers 231b and 232b.

Any one of the first layer 231a or 232a and the second layer 231b or 232b may be formed of a thermosetting resin, and the other may be formed of a thermoplastic resin. For example, the first layers 231a and 232a may be formed of a thermosetting resin, and the second layers 231b and 232b may be formed of a thermoplastic resin.

Conversely, the first layers 231a and 232a may be formed of a thermoplastic resin, and the second layers 231b and 232b may be formed of a thermosetting resin. Here, the second layers 231b and 232b serve to strengthen adhesion.

In another example, both the first layers 231a and 232a and the second layers 231b and 232b may be formed of a thermosetting resin. Here, the second layers 231b and 232b may be thicker than the first layers 231a and 232a. When both the first layers 231a and 232a and the second layers 231b and 232b are formed of the same thermosetting resin, the first layers 231a and 232a and the second layers 231b and 232b may not be visually distinguishable but are formed to be thicker than a thickness of an encapsulant layer including one layer. For example, in the first embodiment, when a thickness of the first encapsulant layer 131 to the fourth encapsulant layer 134 (please refer to FIG. 1) is about 450-550*µ*m, the first encapsulant layer 231 and the second encapsulant layer 232 may be greater than 450*µ*m but smaller than 1100*µ*m.

In the photovoltaic module 200' of the embodiment 2-2 illustrated in FIG. 2A, the first encapsulant layer 231 and the second encapsulant layer 232 are formed of a thermoplastic resin of one layer. Since the first encapsulant layer 231 and the second encapsulant layer 232 have thermoplasticity so that the first encapsulant layer 231 and the second encapsulant layer 232 are melted and then cured in each process of performing heat treatment during a manufacturing process of the photovoltaic module 200' to thus adhere components of the photovoltaic module 200'.

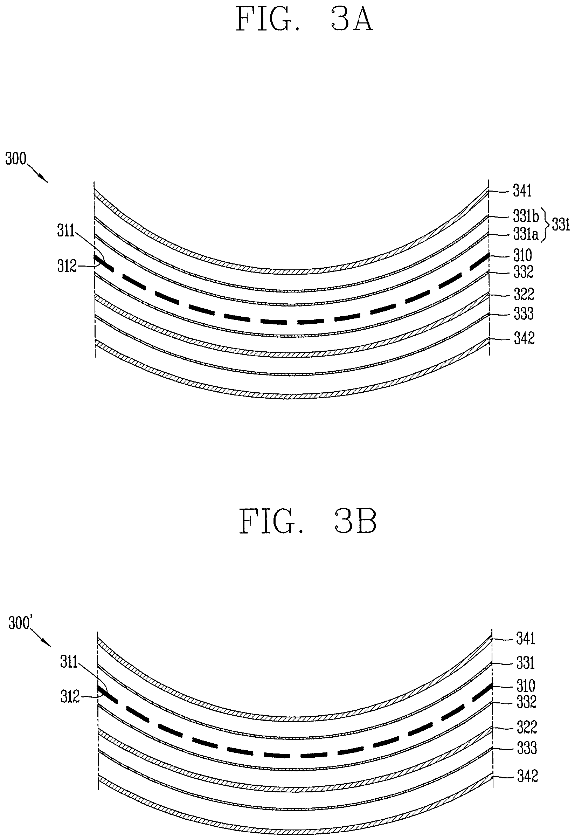

. FIGS. 3A and 3B are conceptual views illustrating photovoltaic modules 300 and 300' of a third embodiment, which does not form a part of the invention and is to be considered as an example suitable for understanding the invention. In FIGS. 3A and 3B, multilayer structures of the photovoltaic modules 300 and 300' are illustrated, respectively.

The photovoltaic modules 300 and 300' of the third embodiment are distinguished from the first and second embodiments described above, in that the photovoltaic modules 300 and 300' include a second film 322, rather than a first film. In the following descriptions, the second film 322 will be referred to as a film 322.

In the photovoltaic modules 300 and 300' of the third embodiment, a first encapsulant layer 331 is disposed between a solar cell 310 and a first glass (a first substrate) 341 and adhered to the solar cell 310 and the first glass 341. The second encapsulant layer 332 is disposed between the solar cell 310 and the film 322 and adhered to the solar cell 310 and the film 322. A third encapsulant layer 333 is disposed between the film 322 and a back sheet or between the film 322 and a second glass (a second substrate) 342 and adhered to the film 322 and the back sheet or adhered to the film 322 and the second glass 342.

The third embodiment may be classified as embodiment 3-1 and embodiment 3-2. The photovoltaic module 300 of the embodiment 3-1 has the first encapsulant layer 331 including two layer, whereas the photovoltaic module 300' of the embodiment 3-2 has the first encapsulant layer 331 including one layer.

In the photovoltaic module 300 of the embodiment 3-1 illustrated in FIG. 3A, the first encapsulant layer 331 includes two layers. A first layer 331a may be formed of a thermosetting resin, and a second layer 331b may be formed of a thermoplastic layer. Also, the second encapsulant layer 332 and the third encapsulant layer 333 may be formed of a thermoplastic resin.

In another example, both the first layer 331a and the second layer 331b of the first encapsulant layer 331 may be formed of a thermosetting resin, and the second encapsulant layer 332 and the third encapsulant layer 333 may be formed of a thermoplastic resin. Here, the second layer 331b may be thicker than the first layer 331a, and the third encapsulant layer 333 may be thicker than the second encapsulant layer 332. This is because the second layer and the third encapsulant layer are adhered to a first glass or a second glass requiring strong adhesion.

In the photovoltaic module 300' of the embodiment 3-2 illustrated in FIG. 3B, the first encapsulant layer 331 is formed of a thermoplastic resin of one layer. The second encapsulant layer 332 may also be formed of a thermoplastic resin, and the third encapsulant layer 333 may be formed of a thermosetting resin. In the photovoltaic modules 300 and 300' having such a structure, a corner of the solar cell 310 is not broken.

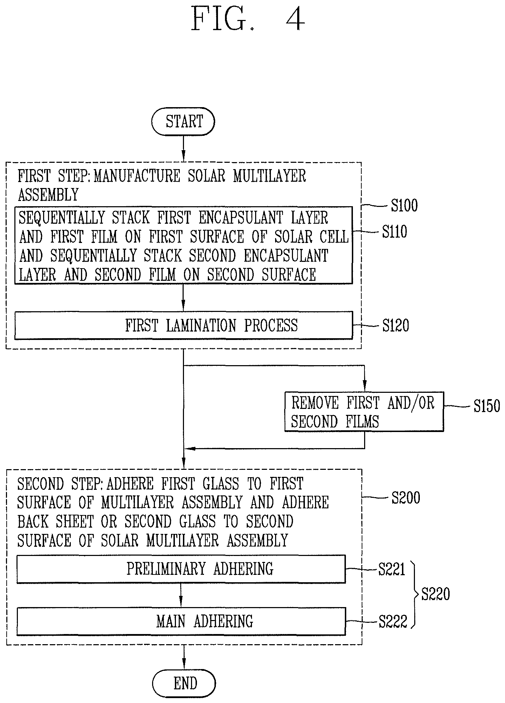

FIG. 4 is a common flow chart illustrating a method for manufacturing photovoltaic modules 100, 200, 200', 300, or 300'

The photovoltaic module 100, 200, 200', 300, or 300' of the present disclosure is manufactured by a first operation S100 and a second operation S200. Also, operation S150 of removing first and/or second film may be provided between the first operation S100 and the second operation S200, but the operation S150 of removing the first and/or second film is not essential and is optional. That is, the operation S150 may be omitted according to an embodiment.

In the first operation S100, a solar laminated assembly is manufactured. The solar laminated assembly refers to a half-finished product previously manufactured during a manufacturing process of the photovoltaic module 100, 200, 200', 300, or 300' and a specific concept thereof may be varied according to embodiments.

In order to manufacture the solar laminated assembly, first, a first encapsulant layer and a first film are sequentially stacked on a first surface of a solar cell, and a second encapsulant layer and a second film are sequentially stacked on a second surface of the solar cell (S110). In the present disclosure, the encapsulant layers may be formed of a thermoplastic resin or a thermosetting resin as mentioned above. Also, at least one of the first film and the second film may be formed of a transparent material as mentioned above.

Here, sequentially stacking refers to a structure in which the first encapsulant layer is stacked on the first surface of the solar cell and the first film is stacked on the first encapsulant layer, rather than order of stacking. For example, it does not exclude stacking the first encapsulant layer and the first film temporally simultaneously on the first surface of the solar cell in a state in which the first film is already stacked on the first encapsulant layer. This descriptions may also be equally applied to the second encapsulant layer and the second film.

Thereafter, through a first lamination process, the first film is adhered to the first surface of the solar cell and the second film is adhered to the second surface of the solar cell (S120). Lamination refers to a process of thermosetting the encapsulant layers formed of a thermosetting resin or a thermoplastic resin by applying heat and pressure to thus adhere two adhering targets disposed on one side and the other side of the encapsulant layer. A specific process of lamination may be different in first and second lamination processes.

In the first lamination process, two adhering targets are a solar cell and films. The first lamination process is performed on a plane. When heat is applied to the first encapsulant layer and the second encapsulant layer, while pressing the first film and the second film in a direction toward each other, the first encapsulant layer and the second encapsulant layer are melted and cured and the first film and the second film are adhered to the first surface and the second surface of the solar cell, respectively.

Pressure applied during the first lamination process is surface pressure. Here, surface pressure refers to pressure equally applied to the entirety of the flat first film and the flat second film, which is to be distinguished from pressure applied only to any partial region.

When the first lamination process is completed, a solar laminated assembly is manufactured. A concept of the solar laminated assembly has been described above with reference to FIG. 1 and may be varied according to embodiments. Since the solar laminated assembly is manufactured by the first lamination process of applying surface pressure, the solar laminated assembly has a planar structure. The first and second encapsulant layers and the first and second films are flexible, and the solar cells are spaced apart from each other. Thus, the solar laminated assembly may be bent to be concave or convex by an external force applied in the second operation S200.

After the solar laminated assembly is manufactured in the first operation S100, the second operation S200 may be immediately performed or operation S150 of removing the first and/or second films may be performed beforehand.

Since there is a temporal interval between the first operation S100 and the second operation S200, the solar laminated assembly manufactured in the first operation S100 is required to be protected from an external influence. The external influence may refer to an influence which may be made on performance of the solar cell such as a physical impact, moisture, or the like. Since the first film and the second film form outermost layers of the solar laminated assembly, the first and second films protect the solar laminated assembly.

When the second operation S200 starts, since the first film and the second film has completed a role of protecting the solar laminated assembly, at least one of the first film and the second film may be removed immediately before the second operation S200 starts. For example, in instance where the first film and the second film are configured as release films, the first film and the second film may be separated and removed from the first encapsulant layer and the second encapsulant layer, respectively.

However, operation S150 of removing the first film and/or the second film is not essential. When the first film and the second film are not removed, the first film and the second film remain on the photovoltaic module 100, 200, 200', 300, or 300', a finished product. Thus, at least one of the first film and the second film remaining in the photovoltaic module 100, 200, 200', 300, and 300' is required to be formed of a transparent material in order to sufficiently supply light to the solar cell.

In a state in which the first film and the second film are present, outermost layers of the solar laminated assembly are formed by the first film and the second film. When the first film and the second film are removed, the first encapsulant layer and the second encapsulant layer are exposed.

In the second operation S200, an encapsulant layer may be additionally selectively disposed before the second lamination process S220. However, whether to additionally disposed an encapsulant layer differs according to embodiments, and thus, details thereof will be described in each embodiment.

Thereafter, in the second operation S200, a first glass is adhered to the first surface of the solar laminated assembly and a back sheet or second glass is adhered to the second surface thereof through the second lamination process S220. The first glass is formed to have a curved surface. The back sheet, which is originally flat, may be bent to have a curvature corresponding to the first glass as it is adhered to the second surface of the solar laminated assembly. In contrast, the second glass is different from the back sheet in that the second glass is originally formed to have a curved surface corresponding to the first glass.

As the first glass and the second glass are formed to have a curved surface, the second lamination process may be performed on a plane. Thus, the second lamination process is performed in a manner different from that of the first lamination process.

The second lamination process includes a preliminary adhering operation S221 and a regular adhering operation S222.

In the preliminary adhering operation S221, the solar laminated assembly is introduced to the inside of a hermetically closed chamber, the inside of the chamber is vacuated and heat is applied to partially melt the encapsulant layer. Thereafter, in the regular adhering operation S222, when heat and pressure are applied, the encapsulant layers are entirely melted and then cured within the hermetically closed chamber, In this instance, the thermoplastic resin which was melted and then cured during the first lamination process is not melted again during the second lamination process.

In the photovoltaic module 100 of the first embodiment, a component for adhering the first glass 141 to the solar laminated assembly 100a is the third encapsulant layer 133, and a component for adhering the back sheet or second glass 142 to the solar laminated assembly 100a is the fourth encapsulant layer. Thus, the third encapsulant layer 133 and the fourth encapsulant layer 134 are partially melted in the preliminary adhering operation S221 of the second lamination process and entirely melted and then cured in the regular adhering operation S222.

In contrast, in the photovoltaic module 200 or 200' of the second embodiment, a component for adhering the first glass to the solar laminated assembly is the first encapsulant layer 231 and a component for adhering the back sheet or second glass 242 to the solar laminated assembly is the second encapsulant layer 232. Thus, the first encapsulant layer 231 and the second encapsulant layer 232 are partially melted in the preliminary adhering operation S221 of the second lamination process and entirely melted and then cured in the regular adhering operation S222.

Also, in the photovoltaic module 300 or 300' of the third embodiment, a component for adhering the first glass to the solar laminated assembly is the first encapsulant layer 331 and a component for adhering the back sheet or second glass 342 to the solar laminated assembly is the third encapsulant layer 333. Thus, the first encapsulant layer 331 and the third encapsulant layer 333 are partially melted in the preliminary adhering operation S221 of the second lamination process and entirely melted and then cured in the regular adhering operation S222.

When the solar laminated assembly is adhered to the first glass 141, 241, or 341 having a curved surface and the back sheet or the second glass 142, 242, or 342 having a curved surface is adhered to the solar laminated assembly through the second lamination process S220 including the preliminary adhering operation S221 and the regular adhering operation S222, the photovoltaic module 100, 200, 200', 300, or 300' is manufactured. The photovoltaic module 100, 200, 200', 300, or 300' manufactured thusly has an overall bent shape, and a curvature of the photovoltaic module 100, 200, 200', 300, or 300' is determined by a curvature of the first glass 141, 241, or 341 and a curvature of the second glass 142, 242, or 342.

When the solar cell is directly adhered to the glass having the curved glass only through the first lamination process, the solar cell may be broken. In the present disclosure, however, the solar laminated assembly is previously manufactured through the first lamination process S120 performed on a plane, and thereafter, the photovoltaic module 100, 200, 200', 300, or 300' is manufactured through the second lamination process S220. Thus, although the photovoltaic module 100, 200, 200', 300, or 300' in a bent form is manufactured, the solar cell is not broken.

Also, when the solar cell is directly adhered to the glass having a curved surface only through the first lamination process, the string connecting the solar cells may slide down the curved surface of the glass to cause a possibility that the photovoltaic module is manufactured to be different from the original design. However, in the present disclosure, since the solar laminated assembly is previously manufactured through the first lamination process S120 performed on the plane, although the solar laminated assembly is adhered to the first glass 141, 241, or 341 having a curved surface through the second lamination process S220, the problem in which the solar cells slide down does not arise.

In addition, if both of the two outermost layers of the photovoltaic module are formed of glass, bubbles may be generated within the photovoltaic module due to an operation between the solar cell and a ribbon structure. However, in the present disclosure, since the solar laminated assembly is previously manufactured through the first lamination process S120, although the first glass 141, 241, or 341 having a curved surface and the second glass 142, 242, or 342 having a curved surface form the outermost layers of the photovoltaic module 100, 200, 200', 300, or 300', bubbles may not be generated.

Hereinafter, a detailed process of manufacturing the photovoltaic modules 100, 200, 200', 300, and 300' of the first to third embodiments will be described. Descriptions of a common method thereof will be replaced with the descriptions of FIG. 4 and only different components of each embodiment will be described.

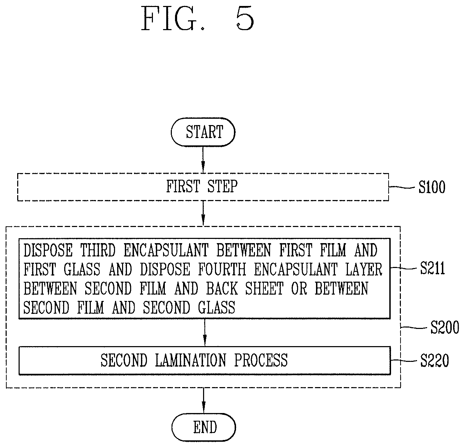

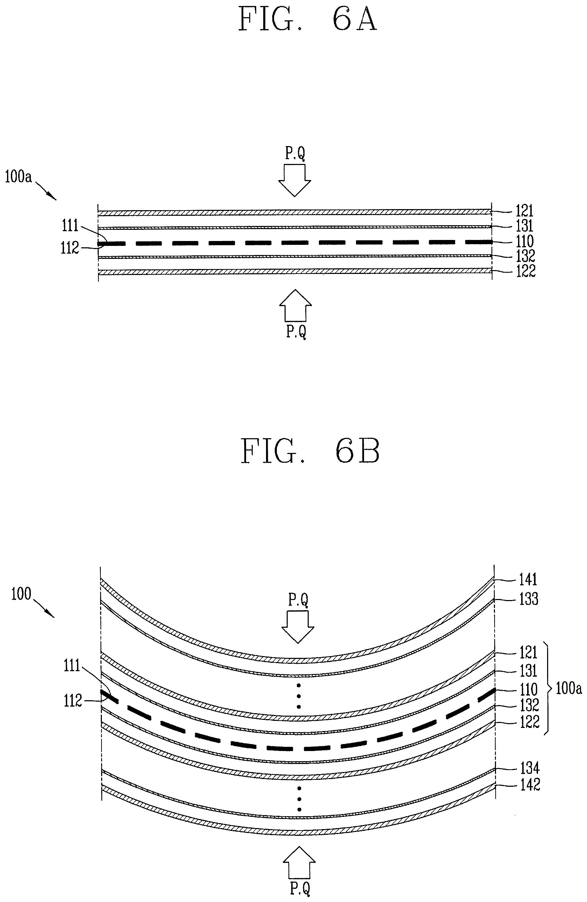

FIG. 5 is a detailed flow chart illustrating a method for manufacturing a photovoltaic module according to a first embodiment, which does not form a part of the invention and is to be considered as an example suitable for understanding the invention. FIGS. 6A and 6B are conceptual views illustrating a process of manufacturing the photovoltaic module 100 according to the flow charts illustrated in FIGS. 4 and 5.

In FIG. 6A, the first lamination process of the first operation S100 is illustrated. The first film 121 is adhered to the first surface 111 of the solar cell 110 as the first encapsulant layer 131 is thermally cured, and the second film 122 is adhered to the second surface 112 of the solar cell 110 as the second encapsulant layer 132 is thermally cured.

Since the photovoltaic module 100 of the first embodiment are required to include the first film 121 and the second film 122, the first film 121 and the second film 122 are not removed after operation S100.

In the photovoltaic module 100 of the first embodiment, the first to fourth encapsulant layers 131, 132, 133, and 134 may be formed of a thermosetting resin or a thermoplastic resin.

Once the thermosetting resin is thermally cured, the thermosetting resin is not deformed although heat is applied again thereto. Thus, the first encapsulant layer 131 and the second encapsulant layer 132 cured through the first lamination process in the first operation S100 are not deformed although heat is applied through the second lamination process S220 described hereinafter. Meanwhile, although the thermoplastic resin is thermally cured through the first lamination process, when heat is applied again through the second lamination process S220, the thermoplastic resin is melted and thermally cured.

Referring to FIG. 5, in the second operation S200, the third encapsulant layer 133 is disposed between the first film 121 and the first glass 141 and the fourth encapsulant layer 134 is disposed between the second film 122 and the back sheet or between the second film 122 and the second glass 142. Accordingly, a structure in which the first encapsulant layer 131, the first film 121, the third encapsulant layer 133, and the first glass 141 are sequentially stacked is formed on the first surface 111 of the solar cell 110. Also, a structure in which the second encapsulant layer 132, the second film 122, the fourth encapsulant layer 134, and the back sheet or the second glass 142 are sequentially stacked is formed on the second surface 112 of the solar cell 110.

Thereafter, the first glass 141 is adhered to the first film 121 through the second lamination process S220, and the back sheet or second glass 142 is adhered to the second film 122. Details of the second lamination process has been described above with reference to FIG. 4. As the third encapsulant layer 133 is thermally cured, the first glass 141 is adhered to the first surface of the solar laminated assembly 100a, and as the fourth encapsulant layer 134 is thermally cured, the back sheet or second glass 142 is adhered to the second surface of the solar laminated assembly 100a. In this embodiment, the first surface of the solar laminated assembly 100a refers to the first film 121, and the second surface thereof refers to the second film 122.

FIG. 6B illustrates that the first glass 141 is adhered to the first film 121 and the back sheet or second glass 142 is adhered to the second film 122 through the second lamination process S220.

Since the first glass 141 is formed to have a curved surface, when the solar laminated assembly 100a is adhered to the first glass 141, the solar laminated assembly 100a is naturally bent to have the same curvature as that of the first glass 141. Similarly, when the back sheet is adhered to the solar laminated assembly 100a, the back sheet is bent to have the same curvature as that of the first glass 141.

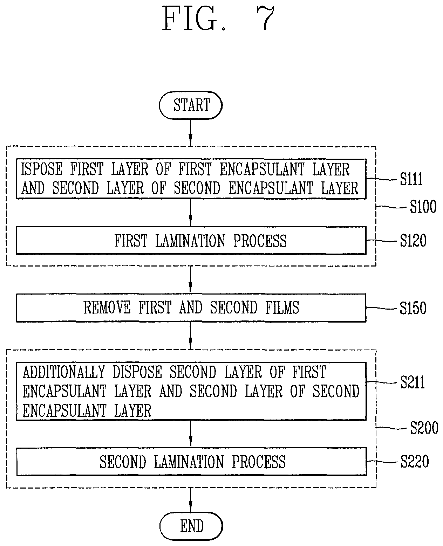

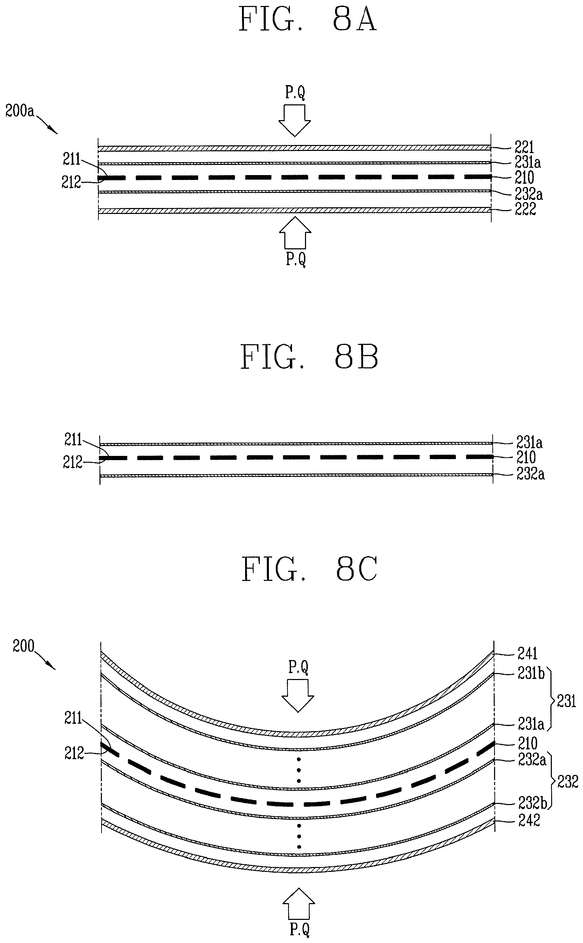

FIG. 7 is a detailed flow chart illustrating a method for manufacturing a photovoltaic module according to a second embodiment of the invention. FIGS. 8A to 8C are conceptual views illustrating a process of manufacturing a photovoltaic module 200 according to the flow charts illustrated in FIGS. 4 and 7.

In FIG. 8A, the first lamination process S120 of the first operation S100 is illustrated. As the first layer 231a of the first encapsulant layer 231 is thermally cured, the first film 221 is adhered to the first surface 211 of the solar cell 210, and as the first layer 232a of the second encapsulant layer 232 is thermally cured, the second film 222 is adhered to the second surface 212 of the solar cell 210.

The first film 221 and the second film 222 are formed as release films, and the photovoltaic module 200 of the second embodiment does not include the first film 221 and the second film 222. Thus, after the first operation S110, the first film 221 and the second film 222 are removed (S150). Also, in FIG. 8B, the solar laminated assembly 200a after removing the first film 221 and the second film 222 is illustrated.

Referring to FIG. 7, in the second operation S200, a second layer 231b of the first encapsulant layer 231 is additionally disposed between the first film 221 and the first glass 241 and the second layer 232b of the second encapsulant layer 232 is additionally disposed between the second film 222 and the back sheet or between the second film 222 and the second glass 242 (S211).

In the photovoltaic module 200 of the second embodiment, the first encapsulant layers 231a and 231b and the second encapsulant layers 232a and 232b may each include two layers, and, among the two layers, the first layers 231a and 232a are adhered to the solar cell 21 in a first operation. Also, the second layers 231b and 232b are adhered to the first glass 241a and the back sheet or second glass 242 in a second operation. The first layers 231a and 232a may be formed of a thermosetting resin or a thermoplastic resin, and the second layers 231b and 232b may be formed of a thermosetting resin.

When the first layers 231a and 232a are formed of a thermoplastic resin and the second layers 231b and 232b are formed of a thermosetting resin, the second layers 231b and 232b are added in the second operation to enhance adhesion.

When both the first layers 231a and 232a and the second layers 231b and 232b are formed of a thermosetting resin, a thickness of the second layers 231b and 232b may be greater than that of the first layers 231a and 232a. This is because the second layers 231b and 232b are adhered to the first glass 2421 and the back sheet or second glass 242 requiring strong adhesion. When both the first layers 231a and 232a and the second layers 231b and 232b are formed of a thermosetting resin, the first layers 231a and 232a and the second layers 231b and 232b have a thickness greater than that of a thermosetting resin of a single layer, as described above.

As the second layer 231b of the first encapsulant layer and the second layer 231b of the second encapsulant layer are additionally disposed, a structure in which the first layer 231a and the second layer 231b of the first encapsulant layer 231 and the first glass 241 are sequentially stacked is formed on the first surface 211 of the solar cell 210. Also, a structure in which the first layer 232a and the second layer 232b of the second encapsulant layer 232 and the back sheet or second glass 242 are sequentially stacked is formed on the second surface 212 of the solar cell 210.

Thereafter, the first glass 241 and the back sheet or second glass 242 are adhered to the solar laminated assembly 200a through the second lamination process S220. Details of the second lamination process has been described above with reference to FIG. 4.

As the second layer 231b of the first encapsulant layer 231 is thermally cured, the first glass 241 is adhered to the first surface of the solar laminated assembly 200a, and as the second layer 232b of the second encapsulant layer 232 is thermally cured, the back sheet or second glass 242 is adhered to the second surface of the solar laminated assembly 200a. Since the first film and the second film have already been removed, here, the first surface of the solar laminated assembly 200a refers to the first layer 231a of the first encapsulant layer 231 and the second surface refers to the first layer 232a of the second encapsulant layer 232.

FIG. 8C illustrates that the first glass 241 is adhered to the first layer 231a and the back sheet or second glass 242 is adhered to the first layer 232a of the second encapsulant layer 232 through the second lamination process S220.

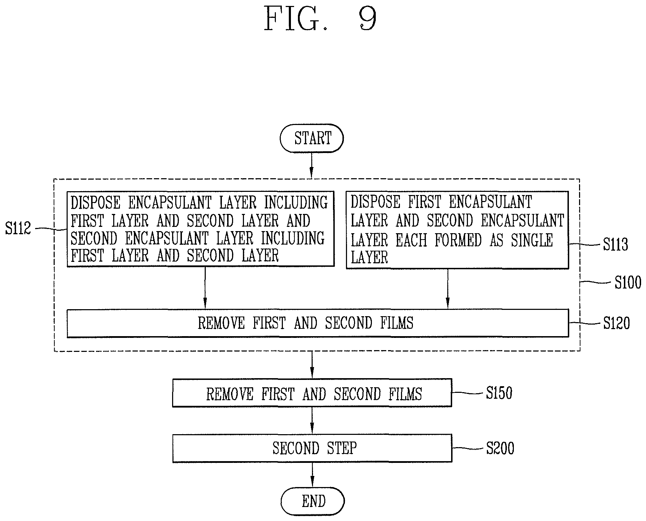

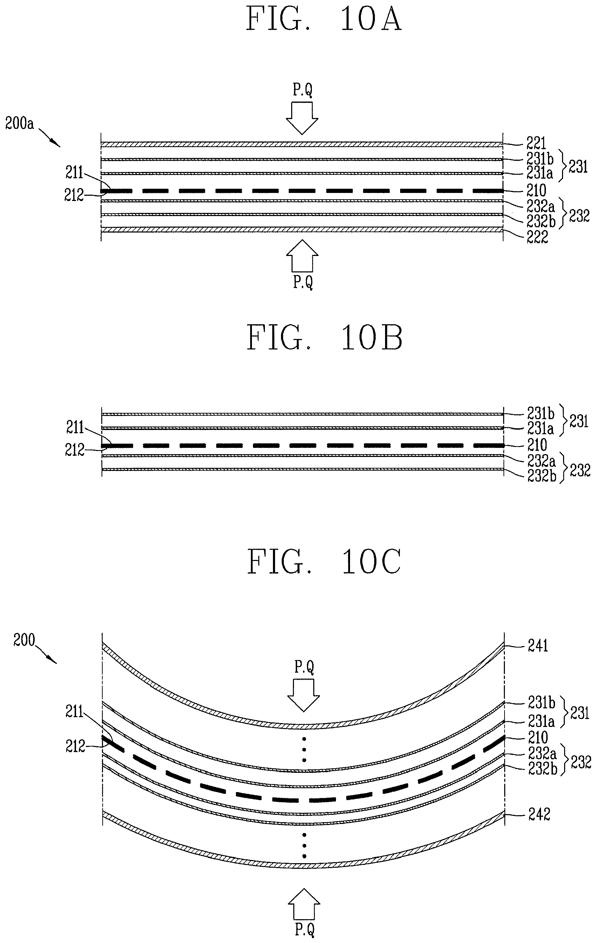

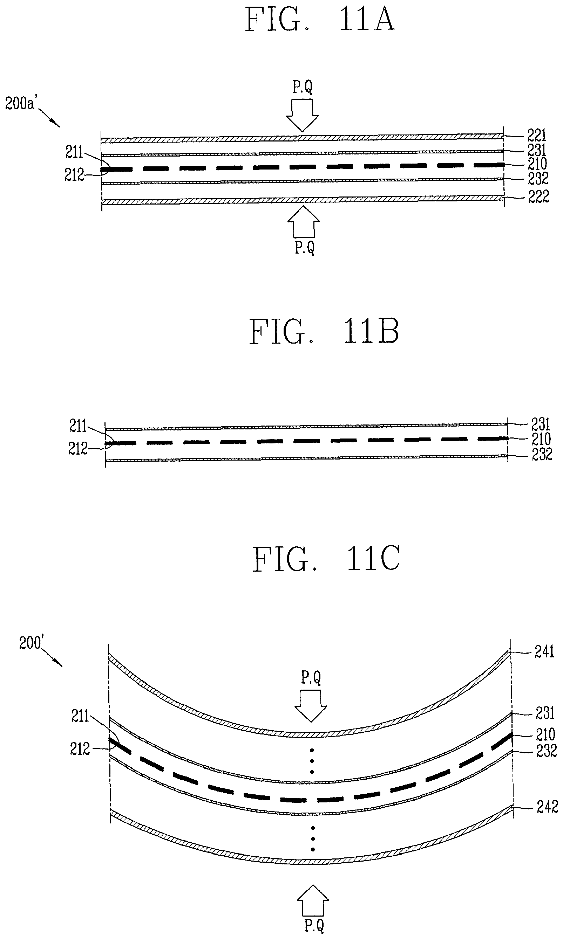

FIG. 9 is a detailed flow chart illustrating another method for manufacturing a photovoltaic module 200 or 200' according to the second embodiment, which does not form a part of the invention and is to be considered as an example suitable for understanding the invention. FIGS. 10A to 10C are conceptual views illustrating a process of manufacturing the photovoltaic module 200 according to the flow charts illustrated in FIS. 4 and 9. FIGS. 11A to 11C are other conceptual views illustrating a process of manufacturing the photovoltaic module 200' according to the flow charts illustrated in FIGS. 4 and 9.

This embodiment is distinguished from the embodiment described above with reference to FIG. 7, in that an encapsulant layer is not added in a second operation. A first encapsulant layer and a second encapsulant layer may each include two layers or one layer. In either instance, the first encapsulant layer and the second encapsulant layer are added only in the first operation to configure the solar laminated assembly, and are not added in the second operation.

In FIG. 9, the first encapsulant layer and the second encapsulant layer each including two layers are added in operation S112, and a corresponding manufacturing process is illustrated in FIGS. 10A to 10C. Also, the first encapsulant layer and the second encapsulant layer each including a single layer are added in operation S113, and a corresponding manufacturing process is illustrated in FIGS. 11A to 11C.

In FIG. 10A, the first lamination process (S120) of the first operation S100 is illustrated. As the first encapsulant layer 231 is thermally cured, the first film 221 is adhered to the first surface 211 of the solar cell 210, and as the second encapsulant layer 232 is thermally cured, the second film 222 is adhered to the second surface 212 of the solar cell 210.

In this embodiment, the first layers 231a and 232a are formed of a thermosetting resin, and the second layers 231b and 232b are formed of a thermoplastic resin. In the first lamination process, both the first layer 231a and the second layer 231b of the first encapsulant layer 231 are thermally cured, and both the first layer 231a and the second layer 231b of the second encapsulant layer 232 are thermally cured. However, since the second layer 231b of the first encapsulant layer 231 and the second layer 232b of the second encapsulant layer 232 are formed of a thermoplastic resin, when the second layer 231b of the first encapsulant layer 231 and the second layer 232b of the second encapsulant layer 232 are re-heated in the second lamination process, they are deformed again.

The first film 221 and the second film 222 are formed as release films, and the photovoltaic module 200 of the second embodiment do not include the first film 221 and the second film 222. Thus, after the first operation S100, the first film 221 and the second film 222 are removed (S150). The second layer 231b of the first encapsulant layer 231 and the second layer 232b of the second encapsulant layer 232 are exposed. In FIG. 10B, the solar laminated assembly 200a after the first film 221 and the second film 222 were removed is illustrated.

In the photovoltaic module 200 of this embodiment, since the second layer 231b of the first encapsulant layer 231 and the second layer 232b of the second encapsulant layer 232 are formed of a thermoplastic resin, although the second layer 231b of the first encapsulant layer 231 and the second layer 232b of the second encapsulant layer 232 are thermally cured by first lamination process, they are deformed when heat is applied thereto again. Thus, an additional encapsulant layer for adhering the first glass 241 or the back sheet or second glass 242 is not required.

In the second operation S200, through the second lamination process S220, the first glass 241 is adhered to the first film 221 and the back sheet or second glass 242 is adhered to the second film 222 without adding an encapsulant layer. Details of the second lamination are the same as that described above with reference to FIG. 4. As the second layer 231b of the first encapsulant layer 231 is thermally cured, the first glass 241 is adhered to the first surface of the solar laminated assembly 200a, and as the second layer 232b of the second encapsulant layer 232 is thermally cured, the back sheet or second glass 242 is adhered to the second glass of the solar laminated assembly 200a.

In FIG. 10C, a process of adhering the first glass 241 to the second layer 231b of the first encapsulant layer 231 and adhering the back sheet or second glass 242 to the second layer 232b of the second encapsulant layer 232 through the second lamination process is illustrated.

In FIG. 11A, the first lamination process S120 of the first operation S100 is illustrated. As the first encapsulant layer 231 is thermally cured, the first film 221 is adhered to the first surface 211 of the solar cell 210, and as the second encapsulant layer 232 is thermally cured, the second film 222 is adhered to the second surface 212 of the solar cell 210 as the second encapsulant layer 232 is thermally cured.

The first film 221 and the second film 222 are formed as release films, and the photovoltaic module 200' of the second embodiment does not include the first film 221 and the second film 222. Thus, after the first operation S100, the first film 221 and the second film 222 are removed (S150). In FIG. 11B, the solar laminated assembly 200a' after removing the first film 221 and the second film 222 is illustrated.

In the photovoltaic module 200' of this embodiment, the first encapsulant layer 231 and the second encapsulant layer 232 are formed of a thermoplastic resin of a single layer. Although the thermoplastic resin is thermally cured by the first lamination process, when heat is applied thereto, the thermoplastic resin is deformed again. Thus, an additional encapsulant layer for adhering the first glass 241 or the back sheet or second glass 242 is not required.

In the second operation S200, without adding a separate encapsulant layer, the first glass 241 is adhered to the first surface of the solar laminated assembly 200a and the back sheet or second glass 242 is adhered to the second surface thereof through the second lamination process S220. Details of the second lamination process is the same as described above with reference to FIG. 4. As the first encapsulant layer 231 is thermally cured again, the first glass 241 is adhered to the first surface of the solar laminated assembly 200a, and as the second encapsulant layer 232 is thermally cured, the back sheet or second glass 242 is adhered to the second surface of the solar laminated assembly 200a. The first encapsulant layer 231 and the second encapsulant layer 232 are heat-treated twice in the first operation S100 and the second operation S200.

In FIG. 11C, a process of adhering the first glass 241 to the first encapsulant layer and adhering the back sheet or second glass 242 to the second encapsulant layer 232 through the second lamination process is illustrated.

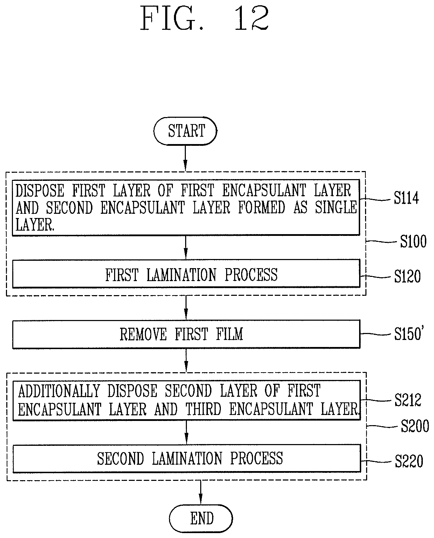

FIG. 12 is a detailed flow chart illustrating a method for manufacturing a photovoltaic module 300 according to a third embodiment, which does not form a part of the invention and is to be considered as an example suitable for understanding the invention. Reference numerals will be referred to FIG. 3A.

In the first operation S100, first, the first layer 331a of the first encapsulant layer 331 is disposed on a first surface 311 of the solar cell 310 and the second encapsulant layer 332 formed of a single layer is disposed on a second surface 312 of the solar cell 310. Also, a first film (not shown) is adhered to the first surface 311 and a second film 322 is adhered to the second surface 312 of the solar cell 310. Accordingly, the solar laminated assembly is formed.

The first layer 331a of the first encapsulant layer 331 and the second encapsulant layer 332 may be formed of a thermosetting resin.

The photovoltaic module 300 of the third embodiment does not include the first film, and the first film is removed between the first operation and the second operation (S150'). In the solar laminated assembly, the first film is removed and the first layer 331a of the first encapsulant layer 331 is exposed.

Thereafter, in the second operation S200, the second layer 331b of the first encapsulant layer 331 is additionally disposed between the first layer 331a of the first encapsulant layer 331 and the first glass 341 and the third encapsulant layer 333 is additionally disposed between the second film 322 and the back sheet or between the second film 322 and the second glass 342 (S212). The second layer 331b and the third encapsulant layer 333 may be formed of a thermosetting resin. Also, in order to ensure strong adhesion, the second layer 331b of the first encapsulant layer 331 may be thicker than the first layer 331a and the third encapsulant layer 333 may be thicker than the second encapsulant layer 332.

Finally, through the second lamination process S220, the first glass 341 is adhered to the first surface of the solar laminated assembly and the back sheet or second glass 342 is adhered to the second surface of the solar laminated assembly.

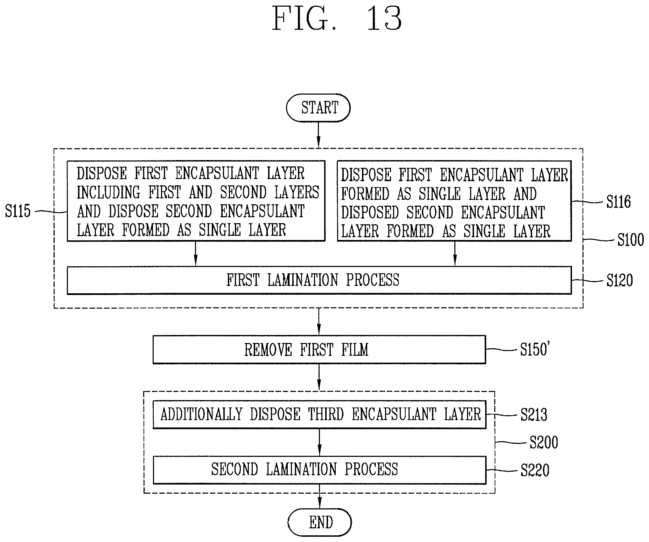

FIG. 13 is a detailed flow chart illustrating another method for manufacturing a photovoltaic module 300 or 300' according to the third embodiment. The method described in FIG. 13, operation S115 and operation S116 are distinguished from each other. The photovoltaic module 300 or 300' of the third embodiment does not include a first film and includes the second film 322, and thus, the first film is removed (S150') between the first operation S100 and the second operation S200 as described above.

First, referring to operation S115, the first encapsulant layer 331 includes the first layer 331a and the second layer 331b, both the two layers 331a and 331b are disposed on the first surface 311 of the solar cell 310 in the first operation S100. Also, the second encapsulant layer 332 formed as a single layer is disposed on the second surface 312 of the solar cell 310. The embodiment of FIG. 13 is distinguished from the embodiment of FIG. 12, in that the two layers 331a and 331b of the first encapsulant layer 331 are disposed on the first surface 311 of the solar cell 310 in the first operation S100 and only the third encapsulant layer 333 is added (S213) in the second operation S200.

The first layer 331a of the first encapsulant layer 331 is formed of a thermosetting resin, and the second layer 331b may be formed of a thermoplastic resin. Also, both the second encapsulant layer 332 and the third encapsulant layer 333 may be formed of a thermosetting resin. Through this embodiment, the photovoltaic module 300 illustrated in FIG. 3A is manufactured, and the other descriptions thereof may be replaced with the above descriptions.

Referring to operation S116, both the first encapsulant layer 331 and the second encapsulant layer 332 are formed as a single layer, and the first encapsulant layer 331 is disposed on the first surface 311 of the solar cell 310 in the first operation S100, and the second encapsulant layer 332 is disposed on the second surface 312 of the solar cell 310. Both the first encapsulant layer 331 and the second encapsulant layer 332 are formed of a thermoplastic resin. Meanwhile, the third encapsulant layer 333 is formed of a thermosetting resin.

Only the third encapsulant layer 333 is added (S213) in the second operation S200, and through this embodiment, the photovoltaic module 300' illustrated in FIG. 3B is manufactured. The other descriptions thereof may be replaced with the above descriptions.

The photovoltaic module and the manufacturing method thereof described above are not limited to the components and methods of the embodiments described above and the entirety or a portion of the embodiments may be selectively combined to various modifications.

According to the present disclosure having the configuration described above, although the outermost layer of the photovoltaic module is formed of glass with a curved surface, since the solar cell is protected by the first lamination process and thus stress applied to the solar cell due to the curved surface is alleviated, the solar cell is not broken. Thus, the photovoltaic module may be applied to a roof of an automobile, an interior or exterior material of a building, and the like, requiring a curved surface functionally or in design.

Also, in the present disclosure, since the solar laminated assembly is previously manufactured through the first lamination process in the first operation and the solar laminated assembly is post-bonded to the curved glass, 1) the problem of generation of bubbles and 2) the problem that an array of strings connecting solar cells slide down the curved surface to break the array of the solar cells do not arise. Thus, when the present disclosure is used, the curved photovoltaic module as initially designed may be manufactured.

The foregoing embodiments and advantages are merely example and are not to be considered as limiting the present disclosure. The present teachings can be readily applied to other types of apparatuses. This description is intended to be illustrative, and not to limit the scope of the claims. Many alternatives, modifications, and variations will be apparent to those skilled in the art. The features, structures, methods, and other characteristics of the example embodiments described herein may be combined in various ways to obtain additional and/or alternative example embodiments.

As the present features may be embodied in several forms without departing from the characteristics thereof, it should also be understood that the above-described embodiments are not limited by any of the details of the foregoing description, unless otherwise specified, but rather should be considered broadly within its scope as defined in the appended claims.

## Claims

1. A method for manufacturing a curved photovoltaic module, the method comprising:
a first laminating operation of manufacturing a solar laminated assembly (200a), wherein the first laminating operation includes:
sequentially stacking a first layer (231a) of a first encapsulant layer (231) and a first film (221) on a first surface (211) of at least one solar cell (210) and sequentially stacking a first layer (232a) of the second encapsulant layer (232) and a second film (222) on a second surface (212) of the at least one solar cell (210); and
adhering the first film (221) to the first surface (211) of the at least one solar cell (210) and adhering the second film (222) to the second surface (212) of the at least one solar cell (210) through a first lamination process of applying heat to the first layers (231a, 232a) of the first and second encapsulant layers (231, 232) while pressing the first film (221) and the second film (222) in a direction toward each other;
removing the first film (221) and the second film (222) from the solar laminated assembly (200a) after the first laminating operation; and
a second laminating operation of encapsulating the solar laminated assembly (200a) between a first substrate (241) having a curved surface and a second substrate (242), wherein the second laminating operation includes:
additionally disposing a second layer (231b) of the first encapsulant layer (231) between the first substrate (241) and the first layer (231a) of the first encapsulant layer (231) exposed by removing the first film (221), and additionally disposing the second layer (232b) of the second encapsulant layer (232) between the second substrate (242) and the first layer (232a) of the second encapsulant layer (232) exposed by removing the second film (222); and
adhering the first substrate (241) to a first surface of the solar laminated assembly (200a) and adhering the second substrate (242) to a second surface of the solar laminated assembly (200a) through a second lamination process of applying heat and pressure within a hermetically closed chamber,
wherein the first encapsulant layer (231) and the second encapsulant layer (232) are formed of a thermosetting resin and stacked as two layers, and
among the two layers, the second layer (231b, 232b) disposed to be relatively further from the at least one solar cell (210) is thicker than the first layer disposed to be relatively closer to the at least one solar cell (210).

2. The method of claim 1, wherein:
the first substrate (241) corresponds to a first glass,
the second substrate (242) corresponds to a second glass or a transparent sheet,
the first layer (231a, 232a) is adhered to the at least one solar cell (210),
the second layer (231b, 232b) is adhered to the first glass (241,), or to the transparent sheet (142) or the second glass (242,), and
the second laminating operation includes adhering the first glass (241) to the first surface of the solar laminated assembly (200a) and adhering the transparent sheet (142) or the second glass (242) to the second surface of the solar laminated assembly (200a) through the second lamination process of applying heat and pressure within a hermetically closed chamber,
the first layer (231a, 232a) is formed of a thermosetting resin and disposed to cover the at least one solar cell (210) in the first laminating operation, and
the second layer (231b, 232b) is formed of a thermosetting resin and disposed to cover the first layer (231a, 232a) in the second laminating operation.

## Patentansprüche

1. Verfahren zum Herstellen eines gekrümmten photovoltaischen Moduls, wobei das Verfahren umfasst:
einen ersten Laminiervorgang zum Herstellen einer laminierten Solaranordnung (200a), wobei der erste Laminiervorgang enthält:
sequenzielles Stapeln einer ersten Schicht (231a) einer ersten Einkapselungsschicht (231) und eines ersten Films (221) auf einer ersten Oberfläche (211) von zumindest einer Solarzelle (210) und sequenzielles Stapeln einer ersten Schicht (232a) der zweiten Einkapselungsschicht (232) und eines zweiten Films (222) auf einer zweiten Oberfläche (212) der zumindest einen Solarzelle (210); und
Aufkleben des ersten Films (221) auf die erste Oberfläche (211) der zumindest einen Solarzelle (210) und Aufkleben des zweiten Films (222) auf die zweite Oberfläche (212) der zumindest einen Solarzelle (210) durch einen ersten Laminierungsprozess zum Aufbringen von Wärme auf die ersten Schichten (231a, 232a) der ersten und zweiten Einkapselungsschichten (231, 232), während der erste Film (221) und der zweite Film (222) in einer Richtung aufeinander zu gedrückt werden;
Entfernen des ersten Films (221) und des zweiten Films (222) von der laminierten Solaranordnung (200a) nach dem ersten Laminiervorgang; und
einen zweiten Laminiervorgang zum Einkapseln der laminierten Solaranordnung (200a) zwischen einem ersten Substrat (241) mit einer gekrümmten Oberfläche und einem zweiten Substrat (242), wobei der zweite Laminiervorgang enthält:
zusätzliches Anordnen einer zweiten Schicht (231b) der ersten Einkapselungsschicht (231) zwischen dem ersten Substrat (241) und der ersten Schicht (231a) der durch Entfernen des ersten Films (221) freigelegten ersten Einkapselungsschicht (231), und zusätzliches Anordnen der zweiten Schicht (232b) der zweiten Einkapselungsschicht (232) zwischen dem zweiten Substrat (242) und der ersten Schicht (232a) der durch Entfernen des zweiten Films (222) freigelegten zweiten Einkapselungsschicht (232); und
Aufkleben des ersten Substrats (241) auf eine erste Oberfläche der laminierten Solaranordnung (200a) und Aufkleben des zweiten Substrats (242) auf eine zweite Oberfläche der laminierten Solaranordnung (200a) durch einen zweiten Laminierungsprozess zum Anwenden von Wärme und Druck innerhalb einer hermetisch geschlossenen Kammer,
wobei die erste Einkapselungsschicht (231) und die zweite Einkapselungsschicht (232) aus einem wärmehärtenden Harz gebildet und als zwei Schichten gestapelt sind, und
wobei, von den zwei Schichten, die zweite Schicht (231b, 232b), die relativ weiter von der zumindest einen Solarzelle (210) entfernt angeordnet ist, dicker als die erste Schicht ist, die relativ näher zu der zumindest einen Solarzelle (210) angeordnet ist.

2. Verfahren nach Anspruch 1, wobei:
das erste Substrat (241) einem ersten Glas entspricht,
das zweite Substrat (242) einem zweiten Glas oder einer transparenten Folie entspricht,
die erste Schicht (231a, 232a) auf die zumindest eine Solarzelle (210) aufgeklebt ist,
die zweite Schicht (231b, 232b) auf das erste Glas (241) oder auf die transparente Folie (142) oder das zweite Glas (242) geklebt ist, und
der zweite Laminiervorgang ein Ankleben des ersten Glases (241) auf die erste Oberfläche der laminierten Solaranordnung (200a) und ein Ankleben der transparenten Folie (142) oder des zweiten Glases (242) auf die zweite Oberfläche der laminierten Solaranordnung (200a) durch den zweiten Laminierungsprozess zum Anwenden von Wärme und Druck innerhalb einer hermetisch geschlossenen Kammer umfasst,
die erste Schicht (231a, 232a) aus einem wärmehärtenden Harz gebildet und angeordnet ist, um die zumindest eine Solarzelle (210) im ersten Laminiervorgang zu bedecken, und
die zweite Schicht (231b, 232b) aus einem wärmehärtenden Harz gebildet und angeordnet ist, um die erste Schicht (231a, 232a) im zweiten Laminiervorgang zu bedecken.

## Revendications

1. Procédé de fabrication d'un module photovoltaïque incurvé, le procédé comprenant :
une première opération de stratification de fabrication d'un ensemble solaire stratifié (200a), dans laquelle la première opération de stratification comprend :
l'empilement de manière séquentielle d'une première couche (231a) d'une première couche d'agent d'encapsulation (231) et d'un premier film (221) sur une première surface (211) d'au moins une cellule solaire (210) et l'empilement de manière séquentielle d'une première couche (232a) de la seconde couche d'agent d'encapsulation (232) et d'un second film (222) sur une seconde surface (212) de la ou des cellules solaires (210) ; et
le collage du premier film (221) à la première surface (211) de la ou des cellules solaires (210) et le collage du second film (222) à la seconde surface (212) de la ou des cellules solaires (210) par un premier processus de stratification d'application de chaleur aux premières couches (231a, 232a) des première et seconde couches d'agent d'encapsulation (231, 232) tout en pressant le premier film (221) et le second film (222) dans une direction l'un vers l'autre ;
le retrait du premier film (221) et du second film (222) de l'ensemble solaire stratifié (200a) après la première opération de stratification ; et
une seconde opération de stratification d'encapsulation de l'ensemble solaire stratifié (200a) entre un premier substrat (241) ayant une surface incurvée et un second substrat (242), dans laquelle la seconde opération de stratification comprend :
la disposition, en outre, d'une seconde couche (231b) de la première couche d'agent d'encapsulation (231) entre le premier substrat (241) et la première couche (231a) de la première couche d'agent d'encapsulation (231) exposée en retirant le premier film (221), et la disposition, en outre, de la seconde couche (232b) de la seconde couche d'agent d'encapsulation (232) entre le second substrat (242) et la première couche (232a) de la seconde couche d'agent d'encapsulation (232) exposée en retirant le second film (222) ; et
le collage du premier substrat (241) à une première surface de l'ensemble solaire stratifié (200a) et le collage du second substrat (242) à une seconde surface de l'ensemble solaire stratifié (200a) par le biais d'un second processus de stratification d'application de chaleur et de pression au sein d'une chambre hermétiquement fermée,
dans lequel la première couche d'agent d'encapsulation (231) et la seconde couche d'agent d'encapsulation (232) sont formées d'une résine thermodurcissable et empilées en deux couches, et
parmi les deux couches, la seconde couche (231b, 232b) disposée pour être relativement plus éloignée de la ou des cellules solaires (210) est plus épaisse que la première couche disposée pour être relativement plus proche de la ou des cellules solaires (210).

2. Procédé selon la revendication 1, dans lequel :
le premier substrat (241) correspond à un premier verre,
le second substrat (242) correspond à un second verre ou à une feuille transparente,
la première couche (231a, 232a) est collée à la ou aux cellules solaires (210),
la seconde couche (231b, 232b) est collée au premier verre (241,), ou à la feuille transparente (142) ou au second verre (242,), et
la seconde opération de stratification comprend le collage du premier verre (241) sur la première surface de l'ensemble solaire stratifié (200a) et le collage de la feuille transparente (142) ou du second verre (242) sur la seconde surface de l'ensemble solaire stratifié (200a) par le biais du second processus de stratification d'application de chaleur et de pression au sein d'une chambre hermétiquement fermée,
la première couche (231a, 232a) est formée d'une résine thermodurcissable et disposée pour recouvrir la ou les cellules solaires (210) lors de la première opération de stratification, et
la seconde couche (231b, 232b) est formée d'une résine thermodurcissable et disposée pour recouvrir la première couche (231a, 232a) lors de la seconde opération de stratification.
